# EUROPEAN PATENT APPLICATION

(11) **EP 2 246 881 A2**
(43) Date of publication of application: **03.11.2010**
(21) Application number: 09712696.5
(22) Date of filing: 19.02.2009
(51) Int. Cl.: H01L 21/60

(54) **JOINING STRUCTURE AND A SUBSTRATE-JOINING METHOD USING THE SAME**

(30) Priority: 22.02.2008 KR 20080016332
(71) Applicant: Barun Electronics Co., Ltd., Gyeonggi-do 449-884 (KR)
(72) Inventor: KIM, Sung Wook, c/o Barun Electronics Co., Ltd., Seoul 137-941 (KR)
(74) Representative: Karl, Frank
(86) International application number: PCT/KR2009/000791
(87) International publication number: WO 2009/104910

(57) **Abstract**

The present invention concerns a joining structure and a substrate-joining method using the same. The joining structure comprises a substrate, and comprises a plurality of joining patterns which are located on the said substrate and which are spaced apart from each other. The substrate-joining method using the joining structure can comprise: a stage involving the formation of a plurality of joining patterns which are spaced apart from each other on a first substrate; and a stage of joining a second substrate on the plurality of joining patterns. When the said joining structure is employed, it is possible to reduce or prevent damage due to spreading of the joining substance during joining of the two substrates.

## Description

### Field of the Invention

Embodiments of the present invention relate to a bonding structure and a substrate bonding method using the same.

### Background of the Invention

In order to hermetically mount or vacuum mount a semiconductor device, two substrates need to be bonded. When bonding two substrates, a bonding material may be applied to either one or both of the two substrates. As a form of the bonding material changes during bonding, hermetic mounting or vacuum mounting of the two substrates is accomplished.

A structure, such as a circuit, requiring protection may be located inside the bonding material on the substrates. Moreover, a pad or the like for electrical connection with an external device may be located outside the bonding material. During the bonding of the two substrates, if the bonding material spreads and comes in contact with the structure inside the bonding material or the pad outside the bonding material, this may deteriorate an operation of the structure or the pad.

### Summary of the Invention

Therefore, the present invention provides a bonding structure capable of reducing or preventing damage caused by spreading of a bonding material during the bonding of two substrates, and a substrate bonding method using the same.

In accordance with an aspect of the present invention, there is provided a bonding structure including: a substrate; and multiple bonding patterns provided on the substrate and spaced apart from each other.

In accordance with another aspect of the present invention, there is provided a substrate bonding method including: forming multiple bonding patterns spaced apart from each other on a first substrate; and bonding a second substrate on the bonding patterns.

Using the bonding structure in accordance with one embodiment of the present invention, when bonding a substrate to another substrate or the like, it is possible to reduce or prevent damage to a device on the substrate or to a pad for electrical connection between the substrate and an external device caused by spreading of a bonding material.

### Brief Description of the Drawings

Fig. 1 shows a top plan view of a bonding structure in accordance with an embodiment of the present invention;
Fig. 2 depicts a cross-sectional view taken along line A-A' in Fig. 1;
Fig. 3 is a schematic view illustrating the separation distance between bonding patterns;
Fig. 4 is a cross-sectional view showing another structure being bonded to the bonding structure in accordance with the embodiment of the present invention; and
Fig. 5 is a top plan view showing a bonding structure in accordance with another embodiment of the present invention.

### Detailed Description of the Embodiments

Hereinafter, embodiments of the present invention will be described in detail with reference to the accompanying drawings. However, the present invention is not limited to the following embodiments.

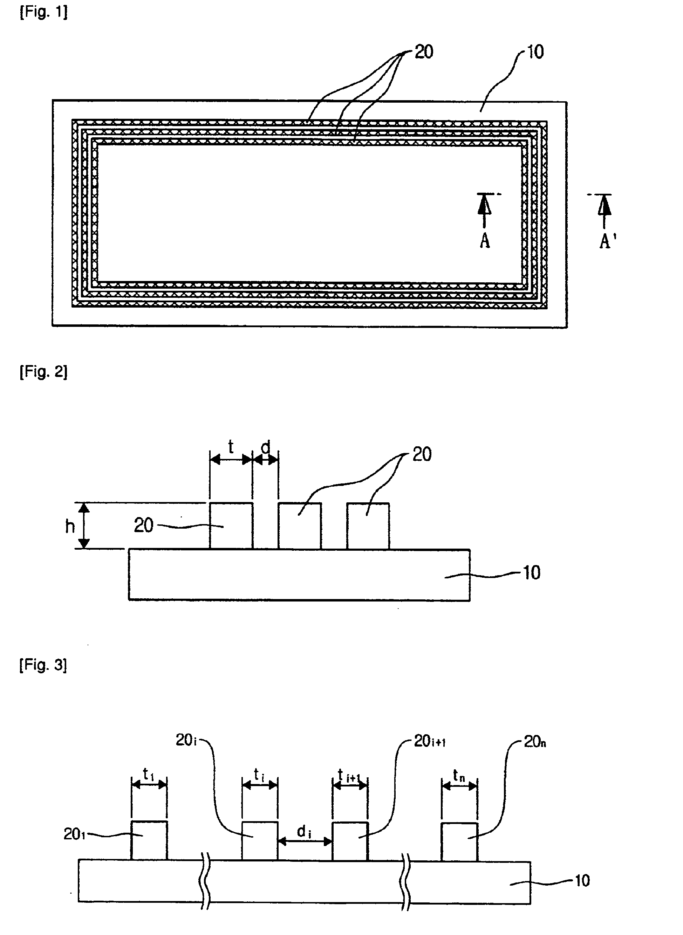

Fig. 1 is a top plan view of a bonding structure in accordance with an embodiment of the present invention, and Fig. 2 is a cross-sectional view taken along line A-A' in Fig. 1.

Referring to Figs. 1 and 2, the bonding structure includes a substrate 10 and multiple bonding patterns 20. The substrate 10 may be formed of glass, silicon, or other appropriate material. Further, a circuit or device, a mechanical structure and the like may be formed on the substrate 10.

The multiple bonding patterns 20 are provided on the substrate 10. The bonding patterns 20 are provided for bonding the substrate 10 to another structure, and may be formed of a material which is capable of bonding. The bonding patterns 20 may include one or several layers.

In an embodiment of the present invention, the bonding patterns 20 are formed in one layer, and the material for the bonding patterns 20 may be a eutectic solder, a high-melting-point solder, a lead-free solder, gold, or a gold alloy.

In another embodiment of the present invention, the bonding patterns 20 are formed in multiple layers, and the bonding patterns 20 may be formed of two or more combinations of various metals, including the aforementioned materials, copper or a copper alloy, titanium or a titanium alloy, chrome or a chrome alloy, nickel or a nickel alloy, aluminum or an aluminum alloy, vanadium or a vanadium alloy and the like.

The bonding patterns 20 are formed by patterning a layer of a bonding material formed on the substrate 10. Meanwhile, the number of bonding patterns 20 shown in Figs. 1 and 2 are for illustrative purposes, and the number of bonding patterns 20 may vary depending upon a size of a substrate to be bonded, constituent materials or the like. Each of the bonding patterns 20 may be formed in a shape suitable to bond the substrate 10 and another structure. For instance, the bonding pattern 20 may have a shape, such as a straight line, a bent line, or a curve. Further, the bonding pattern 20 may have a shape of a closed curve. For example, the bonding pattern 20 may be formed in a closed curve along the outline of the substrate 10.

The bonding pattern 20 having a line shape may be formed with a predetermined height h on the substrate 10. In addition, the line-shaped bonding pattern 20 may have a predetermined thickness t. The thickness t and height h of the bonding pattern 20 may be determined depending on the process of forming a bonding material. The thicknesses t of the bonding patterns 20 may be identical or different with one another. Likewise, the heights h of the bonding patterns 20 may be identical or different.

For instance, in an application where the separation height between the two substrates to be bonded is intended to be small, the height h of the bonding pattern 20 may be identical to or smaller than the thickness t. Even when a high aspect ratio of bonding pattern 20 is required, the height h may be less than 10 times the thickness t. In one embodiment, in a case of using multiple bonding patterns 20, the thickness t of each of the bonding patterns 20 may be about 40 µm, and the height h thereof may be about 30 µm. Meanwhile, each of the bonding patterns 20 may be spaced apart from one another by a predetermined distance d on the substrate 10. The separation distance d between the bonding patterns 20 may be determined based on the height h and thickness t of the bonding patterns 20 and a process of forming the bonding patterns 20.

In one embodiment, the separation distance d between the bonding patterns 20 may be 1/2 of the sum of the thicknesses t of adjacent bonding patterns 20. However, in consideration of a process margin, the separation distance d may be less than the sum of the thicknesses t of the adjacent bonding patterns 20. That is, when the thicknesses t of the adjacent bonding patterns 20 are identical with one another, the separation distance d may be less than two times (2t) the thickness t.

Additionally, in another embodiment, in case where some of the materials of the bonding patterns 20 are used for bonding, the separation distance d between the bonding patterns 20 may be less than 1/2 of the sum of the thicknesses t of adjacent bonding patterns 20.

Fig. 3 shows a schematic view for explaining the separation distance between bonding patterns in a bonding structure.

The schematic view of Fig. 3 is an exemplary one in which an n-number of bonding patterns 20₁ to 20ₙ are formed on a substrate. Here, n is an arbitrary natural number, and Fig. 3 shows only some of the n-number of bonding patterns 20₁ to 20ₙ and the number of bonding patterns 20₁ to 20ₙ is not limited to a specific number.

Referring to Fig. 3, for instance, the separation distance between an i-th bonding pattern 20i and an (i+1)-th bonding pattern 20i₊₁ adjacent to each other is denoted by di, and the thicknesses of the i-th bonding pattern 20i and the (i+1)-th bonding pattern 20i₊₁ are denoted by ti and ti₊₁, respectively. In this case, the i-th bonding pattern 20i and the (i+1)-th bonding pattern 20i₊₁ may have the same thickness (i.e., ti=ti₊₁), or have a different thickness (i.e., tᵢ≠tᵢ₊₁).

Assuming that all the materials of the bonding pattern 20 are used for bonding and spread evenly, the separation distance di between the i-th bonding pattern 20i and the (i+1)-th bonding pattern 20ᵢ₊₁ may be equal to 1/2 of the sum of the thicknesses ti and tᵢ₊₁ of the adjacent bonding patterns 20i and 20ᵢ₊₁. However, in consideration of a process variation in the thicknesses t of the bonding patterns 20i and 20ᵢ₊₁, the separation distance di may be less than the sum of the thicknesses ti and tᵢ₊₁ of the bonding patterns 20i and 20ᵢ₊₁.

For instance, in one embodiment, in case where the heights of the i-th bonding pattern 20i and the (i+1)-th bonding pattern 20ᵢ₊₁ are commonly about 30 µm, and the thicknesses ti and tᵢ₊₁ thereof are about 40 µm and about 30 µm, respectively, if all the materials of both of the bonding patterns 20i and 20ᵢ₊₁ spread to the space between the bonding patterns 20i and 20ᵢ₊₁, the separation distance di between the bonding patterns 20i and 20ᵢ₊₁ may be less than about 70 µm.

In another embodiment, in case where some of the materials of the bonding patterns 20i and 20ᵢ₊₁ are used for bonding and remainders thereof keep the separation distance between the bonding substrates, the separation distance di between the two bonding patterns 20i and 20ᵢ₊₁ may be less than 1/2 of the sum of the thicknesses ti and tᵢ₊₁ of the two bonding patterns 20i and 20ᵢ₊₁. For example, if it is assumed that only half parts of the i-th bonding pattern 20i and the (i+1)-th bonding pattern 20ᵢ₊₁, whose thicknesses ti and tᵢ₊₁ are about 40 µm and about 30 µm, respectively, are used for bonding, the separation distance di between the two bonding patterns 20i and 20ᵢ₊₁ may be less than about 35 µm.

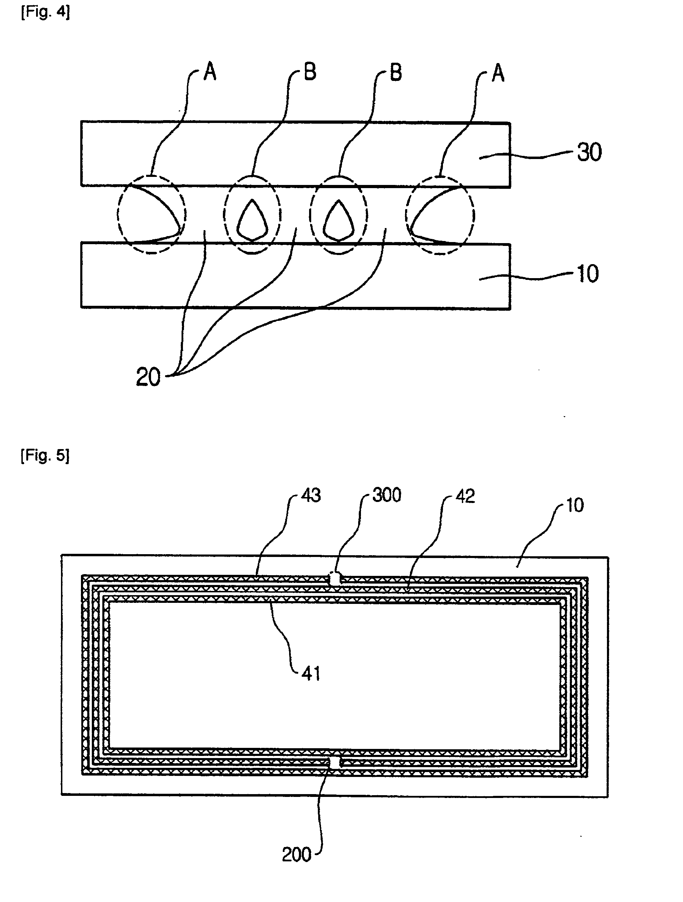

Fig. 4 is a cross-sectional view showing the bonding structure bonded to an external substrate in accordance with the embodiment.

Referring to Fig. 4, a substrate 30 is bonded on top of multiple bonding patterns 20. For example, the substrate 30 is provided on the bonding patterns 20 and heat and/or pressure is applied between the two substrates 10 and 30 to partially melt the bonding patterns 20. The metal patterns 20 and the substrate 30 may be bonded together by the molten materials of the bonding patterns 20. The substrate 30 may include glass, silicon, or other suitable materials.

Meanwhile, each of the bonding patterns 20 spreads in a horizontal direction on the substrate 10 as it melts. The bonding patterns 20 spread to regions B between the bonding patterns 20 because the bonding patterns 20 are spaced apart from one another. As each of the bonding patterns 20 spreads in the horizontal direction, the bonding patterns 20 can be connected to each other. Since the bonding patterns 20 spread to the regions B between the bonding patterns 20, the bonding force between the bonding patterns 20 and the substrate 30 may be relatively improved without increasing regions of the bonding patterns 20.

Moreover, since the bonding patterns 20 spread to the regions B between the bonding patterns 20, the amount of the materials of the bonding patterns 20 spreading to regions A outside the regions of the bonding patterns 20 may be relatively reduced. Therefore, it is possible to reduce or prevent deterioration of the operation of a device or pad on the substrate 10 which can be caused by externally spreading of the materials of the bonding patterns 20.

Fig. 5 is a top plan view showing a bonding structure in accordance with another embodiment of the present invention.

Referring to Fig. 5, the bonding structure includes a substrate 10 and multiple bonding patterns 41, 42, and 43. The configuration of the substrate 10 is substantially identical to the previous embodiment described with reference to Figs. 1 to 4. Therefore, a detailed description thereof will be omitted.
The bonding patterns 41, 42, and 43 are provided on the substrate 10 and are spaced apart from one another. The bonding patterns 41, 42, and 43 may be divided into one first bonding pattern 41 and one or more second bonding patterns 42 and 43 depending on shapes.

The number of second bonding patterns 42 and 43 shown in Fig. 5 are for illustrative purposes, and the number of second bonding patterns 42 and 43 may vary depending on a size of a substrate to be bonded, constituent materials and the like.

The first bonding pattern 41 is provided innermost among the bonding patterns 41, 42, and 43. Further, the first bonding pattern 41 has a closed curve shape. One or more second bonding patterns 42 and 43 are provided to sequentially enclose the first bonding pattern 41. Further, the one or more second bonding patterns 42 and 43 may be provided with openings 200 and 300, respectively.

Since the bonding pattern 42 is provided with the opening 200, a gas between the bonding pattern 41 and the bonding pattern 42 can be released from the substrate 10 through the opening 200 even if another structure is bonded onto the bonding patterns 41, 42, and 43. Likewise, a gas between the bonding pattern 42 and the bonding pattern 43 can be released from the substrate 10 through the opening 300 provided in the bonding pattern 43. As a result, gases are prevented from being confined in the space between the bonding patterns 41, 42, and 43, so that a reduction in bonding yield can be avoided.

While the invention has been shown and described with respect to the particular embodiments, it will be understood by those skilled in the art that various changes and modifications may be made without departing from the of the invention as defined in the following claims.
Embodiments of the present invention may be applied to a bonding structure and a substrate bonding method using the same.

## Claims

1. A bonding structure comprising:
a substrate; and
multiple bonding patterns provided on the substrate and spaced apart from each other.

2. The bonding structure of claim 1, wherein the bonding patterns have a shape of a straight line, a bent line, or a curve.

3. The bonding structure of claim 2, wherein the bonding patterns have a closed curve shape.

4. The bonding structure of claim 2, wherein the height of the bonding patterns from the substrate is less than 10 times the thickness of each of the bonding patterns.

5. The bonding structure of claim 2, wherein a distance between adjacent bonding patterns among the multiple bonding patterns is less than the sum of thicknesses of the adjacent bonding patterns.

6. The bonding structure of claim 1, wherein the multiple bonding patterns include:
a first bonding pattern having a closed curve shape; and
one or more second bonding patterns enclosing the first bonding pattern and having openings formed thereon.

7. The bonding structure of claim 1, wherein the bonding patterns are formed of a eutectic solder, a high-melting-point solder, a lead-free solder, gold, or a gold alloy.

8. The bonding structure of claim 1, wherein the bonding patterns include two or more materials selected from the group consisting of a eutectic solder, a high-melting-point solder, a lead-free solder, gold, a gold alloy, copper, a copper alloy, titanium, a titanium alloy, chrome, a chrome alloy, nickel, a nickel alloy, aluminum, an aluminum alloy, vanadium, and a vanadium alloy.

9. A substrate bonding method comprising:
forming multiple bonding patterns spaced apart from each other on a first substrate; and
bonding a second substrate on the multiple bonding patterns.

10. The substrate bonding method of claim 9, where said bonding a second substrate on the multiple bonding patterns includes melting the multiple bonding patterns.

11. The substrate bonding method of claim 9, wherein the multiple bonding patterns have a shape, such as a straight line, a bent line, or a curve.

12. The substrate bonding method of claim 11, wherein the bonding patterns have a closed curve shape.

13. The substrate bonding method of claim 11, wherein the height of the bonding patterns from the first substrate is less than 10 times the thickness of each of the bonding patterns.

14. The substrate bonding method of claim 11, wherein the distance between adjacent bonding patterns among the multiple bonding patterns is less than the sum of the thicknesses of the adjacent bonding patterns.

15. The substrate bonding method of claim 9, wherein the multiple bonding patterns include:
a first bonding pattern having a closed curve shape; and
one or more second bonding patterns enclosing the first bonding pattern and having openings formed thereon.

16. The substrate bonding method of claim 9, wherein the bonding patterns include a eutectic solder, a high-melting-point solder, a lead-free solder, gold, or a gold alloy.

17. The substrate bonding method of claim 9, wherein the bonding patterns include two or more materials selected from the group consisting of a eutectic solder, a high-melting-point solder, a lead-free solder, gold, a gold alloy, copper, a copper alloy, titanium, a titanium alloy, chrome, a chrome alloy, nickel, a nickel alloy, aluminum, an aluminum alloy, vanadium, and a vanadium alloy.
